(19)

Europäisches
Patentamt

European
Patent Office

Office européen
des brevets

(11) **EP 4 503 254 B1**

(12) **EUROPEAN PATENT SPECIFICATION**

(45) Date of publication and mention
of the grant of the patent:
**20.05.2026   Bulletin 2026/21**

(21) Application number: **23189366.0**

(22) Date of filing: **03.08.2023**

(51) International Patent Classification (IPC):
*H01M 10/44* (2006.01)          *G01R 31/367* (2019.01)
*G01R 31/374* (2019.01)          *G01R 31/392* (2019.01)
*H01M 10/48* (2006.01)

(52) Cooperative Patent Classification (CPC):
**H01M 10/443; G01K 7/427; G01R 31/367;**
**H01M 10/48;** G01R 31/374

(54) **SYSTEM AND METHOD FOR MEASURING THE ENTROPIC HEAT COEFFICIENT OF A BATTERY**

SYSTEM UND VERFAHREN ZUR MESSUNG DES ENTROPIE-WÄRMEKOEFFIZIENTEN EINER BATTERIE

SYSTÈME ET PROCÉDÉ DE MESURE DU COEFFICIENT THERMIQUE ENTROPIQUE D'UNE BATTERIE

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(43) Date of publication of application:
**05.02.2025   Bulletin 2025/06**

(73) Proprietor: **Siemens Industry Software NV**
**3001 Leuven (BE)**

(72) Inventors:
• **Autefage, Gabriel**
**69800 Saint Priest (FR)**
• **Li, An**
**69330 Meyzieu (FR)**
• **Mingant, Rémy**
**92852 Rueil-Malmaison Cedex (FR)**
• **Petit, Martin**
**92852 Rueil-Malmaison Cedex (FR)**

(74) Representative: **Siemens Patent Attorneys**
**Postfach 22 16 34**
**80506 München (DE)**

(56) References cited:
**WO-A1-2022/116037**

• **LENZ MARTIN ET AL: "Applying a numerical**
**optimization to determine the entropic heat**
**coefficient of a battery", APPLIED THERMAL**
**ENGINEERING, PERGAMON, OXFORD, GB, vol.**
**211, 12 April 2022 (2022-04-12), XP087042109,**
**ISSN: 1359-4311, [retrieved on 20220412], DOI:**
**10.1016/J.APPLTHERMALENG.2022.118467**

**Description**

The invention relates to a system and a method for measuring the entropic heat coefficient, called hereafter EHC of a battery. Said EHC is defined as a rate of change of a battery open-circuit voltage (hereafter OCV or $U_{oc}$) with respect to its temperature $T_{cell}$, usually written as EHC = $dU_{oc}/dT_{cell}$ [mV/K], wherein said rate is a function of the state-of-charge (hereafter SoC) of the battery. It is an important parameter when calculating or managing the thermal exchanges of a battery with its surrounding environment, which became of high interest with the increasing electrification of vehicles and the attempts to extend the lifetime of batteries as well as to maintain maximum efficiency.

More precisely, the total heat generation $H_{gen}$ for a battery in operation is the sum of an irreversible heat $Q_{irrev}$ (ohmic loss, diffusion loss, etc.) lost by the battery during operation and a reversible heat $Q_{rev}$ resulting from the entropic effect:

$$H_{gen} = Q_{irrev} + Q_{rev} \quad (Eq. \; 1)$$

wherein

$$Q_{irrev} = I \cdot (U_{oc} - U_{batt}) \quad (Eq. \; 2)$$

$$Q_{rev} = I \cdot dU_{oc}/dT_{cell} \cdot T_{cell} \quad (Eq. \; 3)$$

with I being the battery current, $U_{batt}$ its voltage in operation, $T_{cell}$ the battery temperature, and $U_{oc}$ its open-circuit voltage, and wherein the EHC of the battery, i.e. $dU_{oc}/dT_{cell}$ is, as previously explained, a function of the SoC.

Up to now, different methods have been proposed for determining the EHC of a battery. Said methods are for instance:

- the potentiometric method (see for instance X.-F. Zhang et al., "Potentiometric measurement of entropy change for lithium batteries," Phys. Chem. Chem. Phys., vol. 19, no. 15, pp. 9833-9842, Apr. 2017, doi: 10.1039/C6CP08505A);

- the calorimetric method (see for instance N. Damay, C. Forgez, M.-P. Bichat, and G. Friedrich, "Thermal modeling of large prismatic LiFePO4/graphite battery. Coupled thermal and heat generation models for characterization and simulation," Journal of Power Sources, vol. 283, pp. 37-45, Jun. 2015, doi: 10.1016/j.jpowsour.2015.02.091) ;

- the frequency analysis method (see for instance Z. Geng, J. Groot, and T. Thiringer, "A Time- and Cost-Effective Method for Entropic Coefficient Determination of a Large Commercial Battery Cell," IEEE Transactions on Transportation Electrification, vol. 6, no. 1, pp. 257-266, Mar. 2020, doi: 10.1109/TTE.2020.2971454) .

While the potentiometric method provides very accurate results, it however requires a lot of time for determining the EHC of a battery (typically several days up to weeks), needs highly accurate voltage measurement equipment, and only provides discontinuous EHC results (i.e. for some specific SoC values and not for continuous values of SoC).

The calorimetric method is already faster than the potentiometric method (typically 40 hours of tests against 190 hours for the potentiometric method) and still accurate, and additionally enables to get continuous values of the EHC in function of SoC. However, its disadvantages are the need of a specific housing for thermally controlling the surrounding environment of a tested battery, and specific equipment for carrying out the test (e.g. calorimeter, electrochemical impedance spectrometer, etc.).

Finally, the frequency analysis method, which is the fastest method among the three (typically 32h of tests), has the advantage of enabling in-situ measurements, but provides only discontinuous EHC results and presents higher errors results in the obtained EHC values. WO 2022/116037 discloses a method for forecasting electricity generated by a battery. The EHC is obtained by consulting a pre-mapped relationship between SoC and EHC.

LENZ MARTIN ET AL: "Applying a numerical optimization to determine the entropic heat coefficient of a battery",APPLIED THERMAL ENGINEERING, PERGAMON, OXFORD, GB, vol. 211, 12 April 2022, discloses the application of a method determining the EHC based on experiments and numerical optimization.

There is therefore still a need for a system and method capable of quickly determining or measuring the EHC of a battery while providing accurate results, wherein said method and system are simpler in terms of required experimental efforts compared to the existing techniques, and wherein said system and method might be implemented in situ, free of a system or structure configured for enclosing the battery and controlling thermally its surrounding environment.

An objective of the present invention is therefore to propose a method and a system that enable a faster, simpler, and accurate determination of the EHC of a battery.

This objective is achieved according to the present invention by a method and a system for determining the EHC of a battery according to the object of the independent claims. Dependent claims present further advantages of the invention.

The present invention proposes thus a method, preferentially a computer implemented method, for automatically determining the EHC of a battery, the method comprising:

a) receiving or acquiring, notably via a first interface and for said battery, a current, voltage, and temperature of the battery in function of the time, wherein said current, voltage and temperature have been measured simultaneously during a constant charge and discharge cycle, preferably performed at constant ambient temperature. In particular, if the ambient temperature is not constant, then the ambient temperature, current, voltage, and battery temperature, are received or acquired data that have been simultaneously measured in function of the time during said constant charge and discharge cycle;

b) receiving or acquiring, notably via a second interface, an OCV of the battery as a function of its SoC;

c) feeding said current, voltage and battery temperature in function of the time, optionally said ambient temperature, notably the ambient temperature in function of the time if said ambient temperature is not constant, and said OCV in function of the SoC in an identification algorithm based on a battery thermal model, said identification algorithm being configured for determining said EHC as a function of the SoC, wherein, for said determination, the EHC is defined as a function of N+1 real parameters $a_0,...,a_N$ (i.e. $a_0,...,a_N$ taking real values), in other words EHC = dU/dT = f $(a_0,...,a_N)$, said function being for instance a polynomial function of order N, i.e. dU/dT = $a_0 + a_1 \cdot SoC + a_2 \cdot SoC^2 + ... + a_N \cdot SoC^N$, with $a_0, ..., a_N$ being real parameters of the $N^{th}$ order polynomial function. The identification algorithm is configured for determining the value of each real parameter $a_0,...,a_N$, by minimizing a difference between an estimated battery temperature and said measured temperature, wherein the estimated battery temperature is obtained by modeling, with said battery thermal model, a heat generated by the battery during said charge and discharge cycle;

d) outputting, by said identification algorithm and notably via a third interface, the determined EHC as function of the SoC.

The objective of the present invention is also solved by a system configured for automatically determining the EHC of a battery, said system comprising:

- a first interface configured for receiving or acquiring, for said battery, a current, voltage, and temperature of the battery in function of the time, wherein said current, voltage and temperature have been measured simultaneously during a constant charge and discharge cycle, notably performed at ambient temperature, preferentially constant ambient temperature;
- a second interface configured for receiving or acquiring (102) an OCV of the battery as a function of its SoC;
- a memory for storing the OCV, current, voltage, and temperature acquired via the first and second interfaces, and optionally said ambient temperature, notably if not constant;
- a processing unit comprising at least one processor and one or more processor-executable instructions stored on at least one computer-readable storage medium of the system, which might be said memory, wherein said processor-executable instructions comprise instructions that, when executed by said processor:

    - feed said current, voltage and temperature in function of the time, optionally said ambient temperature in function of the time, and said OCV in function of the SoC in an identification algorithm based on a battery thermal model;
    - execute said identification algorithm, the latter being configured for determining said EHC as a function of the SoC, wherein, for said determination, the EHC is defined as a function of N+1 parameters $a_0,...,a_N$ taking real values, wherein the identification algorithm is configured for determining the value of each real parameter $a_0,...,a_N$, by minimizing a difference between an estimated battery temperature and said measured temperature, wherein the estimated battery temperature is obtained by modeling, with said battery thermal model, a heat generated by the battery during said charge and discharge cycle;
    - output, via a third interface, the EHC as function of the SoC as determined by the identification algorithm;

- said third interface notably configured for displaying the determined EHC. Preferentially, the first, second, and third interface are one and the same interface.

Preferentially, in order to optimize the precision of the EHC outputted by the identification algorithm, the present invention further proposes to add a sinus-like curve of the EHC in function of the SoC to said outputted EHC as function of the SoC in order to create a new EHC in function of the SoC, wherein said sinus-like curve is defined by a set of fitting real parameters, and wherein said new EHC is used as a new input to the identification algorithm which is further configured for optimizing the values of said fitting real parameters of said set by minimizing said difference between the estimated battery temperature and said measured temperature, wherein the EHC in function of the SoC that is finally outputted by the identification algorithm is then said new EHC obtained with the optimized values of the fitting real parameters.

Finally, the present invention concerns also a non-transitory machine-readable medium storing instructions executable by a processing unit to cause a computing system to perform the steps of the claimed method.

Preferred but not exclusive embodiments of the invention will now be described with reference to the accompanying drawings, wherein like numbers designate like objects, and which depict in:

Figure 1     Illustration of the variation of an EHC of a battery in function of its SoCs;

Figure 2     Illustration of a preferred embodiment of the method according to the invention;

Figure 3     Examples of variations of (A) current, (B) voltage, and (C) temperature of a battery during constant charge and discharge cycles;

Figure 4     Examples of an OCV curve in function of SoC obtained for the battery of Fig. 3 in charge and in discharge;

Figure 5     Preferred embodiment of a thermal model of a battery;

Figure 6     Illustration of a modeling of an EHC profile in function of SoCs;

Figure 7     Illustration of a preferred embodiment of a first method for determining the EHC for a battery according to the invention;

Figure 8     Example of sinus-like curve used for optimizing the EHC estimated profile;

Figure 9     Illustration of a preferred embodiment of an optimization of said first method for determining the EHC for a battery according to the invention;

Figure 10    Illustration of a preferred embodiment of a system for estimating the EHC according to the invention.

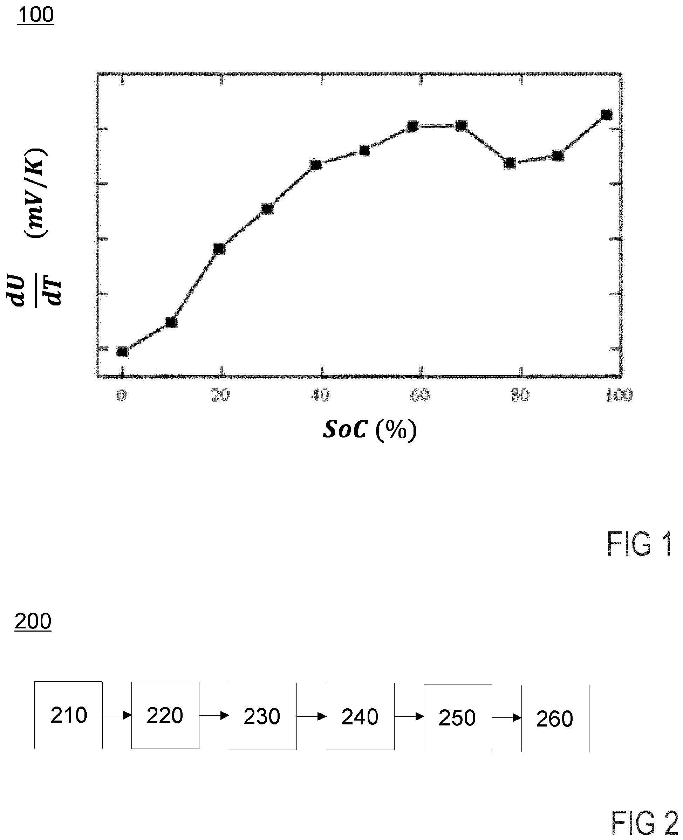

FIGURES 1 through 10, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. The numerous innovative teachings of the present application will be described with reference to exemplary non-limiting embodiments.

The present invention falls in the field of electric battery testing and proposes a fast and simple method to extract the EHC of an electric battery from easily measurable experimental parameters that are typically accessible via sensors and/or directly provided in currently available datasheets characterizing such electric batteries. Compared to existing techniques for extracting the EHC, the proposed technique is notably simpler in terms of experimental instrumentation and faster with respect to the time needed for determining said EHC.

Figure 1 shows a curve representing the variation of the EHC (dU/dT [mV/K]) in function of different SoCs (given in [%] of charge) for a typical lithium-ion battery. As it can be seen from said curve, the EHC increases with SoCs. The present invention proposes to determine such a curve for characterizing a battery by using an identification algorithm that requires simple inputs while outputting an accurately estimated EHC for the battery.

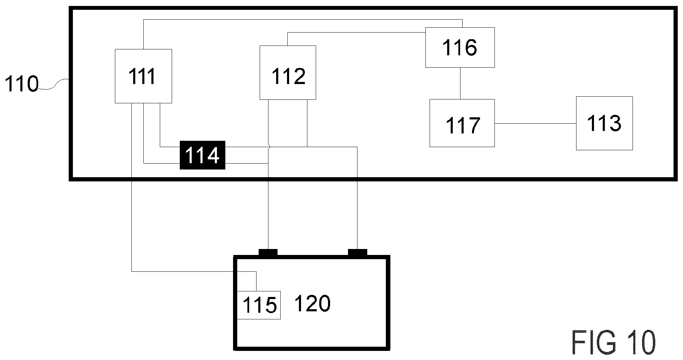

Figure 2 is a flowchart of a preferred embodiment of the method according to the invention. Said method might be implemented by the system 110 schematically illustrated in Fig. 10. Said system 110 is configured for automatically estimating the EHC of a battery 120. Said system 110 comprises notably a first interface 111, a second interface 112, and a third interface 113.

At step 210, the system is configured for receiving or acquiring, notably via its first interface 111, a current, a voltage, and a temperature of the battery in function of the time. Typically, said system 110 comprises connection means, like electric cables, configured for connecting the electrical poles of the battery 120 to one or several measuring devices of the system 110, said measuring devices comprising typically a voltage sensor, a current sensor, and a temperature sensor, in order to enable a measurement of the battery current, voltage, and temperature in function of the time. For instance, a first pair of cables might be configured for connecting the positive (anode) and negative (cathode) poles of the battery 120 to the voltage sensor of a first measuring device 114 as well to a current sensor of said first measuring device 114, current and voltage measurements being thus realized by said first measuring device 114 of the system 110. Preferentially, the system 110 may further comprise a second measuring device comprising a temperature sensor 115 configured for measuring the temperature of said battery 120. Typically, the temperature sensor 115 provides, via another cable or pair of cables, measured temperature values to the system 110 via said interface 111. According to the present invention, the current, voltage and temperature that are acquired or measured by the system 110 have notably been simultaneously measured during a constant charge and discharge cycle that is preferentially performed at constant ambient temperature. If the ambient temperature is not constant, then another temperature sensor of the system 110 might be configured for measuring the ambient temperature in function of the time. Said constant charge and discharge cycle might be performed by the system 110, which, in such case, may comprise a charging device configured for controlling the charging and discharging of the battery 120 in function of the time, said charging device being for instance connected to the first interface 110. Preferentially, said charging device might also measure said current, voltage, and temperature of the battery in function of the time. Alternatively, said charging and discharging might be performed by another charging device not comprised within the system 110 according to the invention. Whatever the method or device used for performing constant charge and discharge cycles, the constant charge and discharge cycle according to the invention comprises preferentially a discharge phase during which the fully charged battery is discharged at constant current until its cut-off voltage, and/or a charge phase during which the battery is charged at a constant current until its maximal voltage is reached. In particular, the charge phase comprises, after reaching said battery maximal voltage, a charge at constant voltage until the battery current decreases to a predefined level (e.g., a small current value of C/20, wherein C is the nominal capacity of the battery).

In other words, the measured current, voltage and temperature are experimental data that characterize the battery for which the EHC has to be determined by the system 110. Part or all said experimental data might be directly determined (i.e. experimentally measured) by the system 110 according to the invention, or data representing the current, and/or voltage, and/or the temperature measured in function of the time for said battery might be acquired by the system 110.

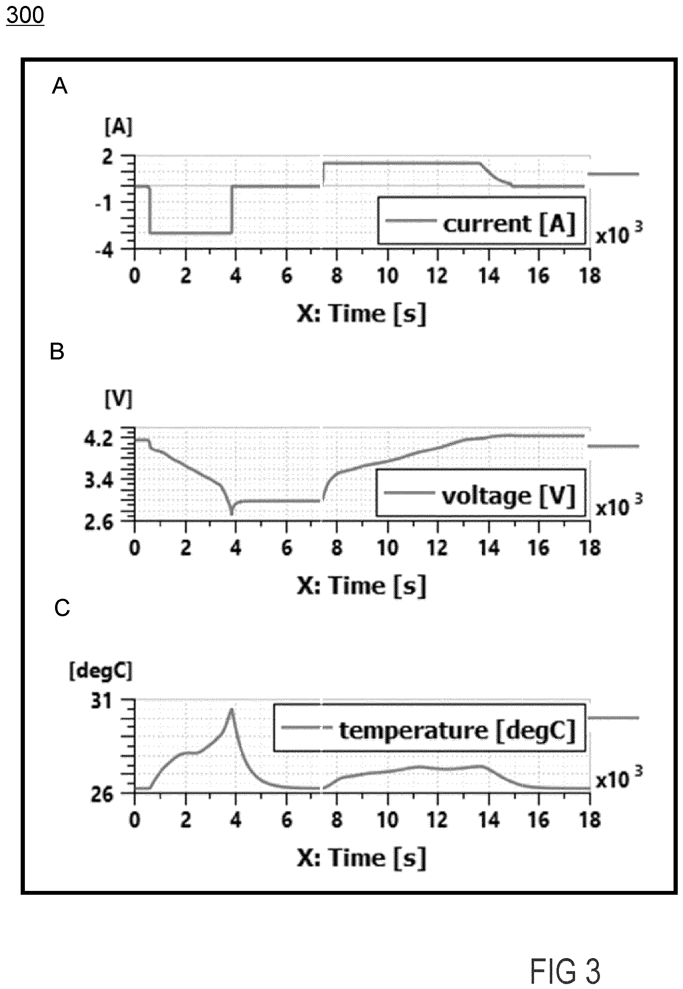

An example of constant charge and discharge cycle is shown in Figure 3. Preferentially, the system 110 according to the invention might be implemented as a battery test bench that may cooperate with a climate chamber for controlling the ambient temperature surrounding the battery. In particular, said ambient temperature might be controlled by the system according to the invention, and/or measured in function of the time simultaneously to the measurement of current, voltage and temperature of the battery. During the acquisition of said current, voltage and temperature, the battery 120 is placed in the climate chamber, preferentially at constant ambient temperature, the system 110 delivering a current to the battery and measuring its current, voltage, and temperature, notably surface temperature during a period of time which is usually less than 5 hours. Graphics A, B, and C of Figure 3 show respectively the measured values for the current, voltage, and temperature for a time period ~18·10$^3$[s].

At step 220, the system 110 is configured for receiving or acquiring, notably via its second interface 112, an OCV of the battery as a function of its SoCs. The OCV is an important parameter of the identification algorithm according to the invention. Preferentially, said OCV is obtained by averaging OCV values obtained by charging the battery and OCV values obtained during discharge of the battery. The OCV in function of the SoC might be directly determined (i.e. experimentally measured) by the system according to the invention, or data representing the OCV of the battery in function of its SoCs might be acquired by the system 110. In order to experimentally determine the OCV for the battery, the system 110 according to the invention may implement different methods.

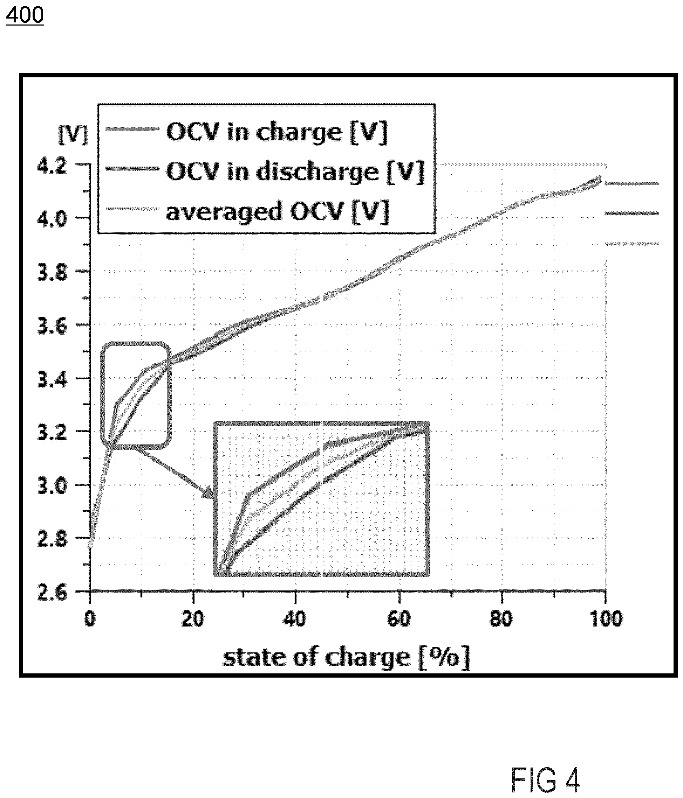

For instance, in order to obtain the OCV in discharge, the system 110 might be configured for discharging the battery successively and discontinuously at different SoCs from 100% to 0%, wherein a relaxation phase is followed after each SoC change. At each SoC, the relaxed voltage at the end of the relaxation phase is considered to be the OCV. Applying the same procedure in charge allows the system to measure the OCV in charge. Figure 4 presents an example of the OCV in charge and in discharge obtained with successive discharges and charges at different SoCs. Preferentially, the system according to invention uses the averaged values between the values of the OCV in discharge and the values of the OCV in charge as input into the identification algorithm according to the invention.

According to another method, the system 110 might be configured for extracting the OCV from a charge and discharge cycle at a small constant current (e.g., at a current of C/20). Again, the average profile of the discharge voltage and the charge voltage is then preferentially used as input to the identification algorithm.

Alternatively, the system 110 might be configured for extracting the OCV by averaging the discharge voltage and charge voltage in a constant discharge and charge cycle as performed in step 210 wherein the charge and discharge internal resistances are considered as equal by the system.

Preferentially, the OCV, current, voltage and temperature (called together "acquired data" hereafter) acquired via the first and second interfaces might be stored in a memory 116 of the system 110. The latter further typically comprises a processing unit 117 for processing the acquired data. Said processing unit 117 may comprise one or several processors and one or more processor-executable instructions stored on at least one computer-readable storage medium of the system, e.g. the memory 116. The execution of said instructions by said one or several processors is configured for implementing the processing of the acquired data according to the invention in order to estimate the EHC in function of the SoC of the battery.

More precisely, the processing unit 117 comprises therefore instructions, which, when executed by the processor, are configured, at step 230, for feeding said current, voltage and temperature in function of the time and said OCV in function of the SoC in an identification algorithm based on a battery thermal model. The identification algorithm enables to identify or determine different thermal parameters of the battery, namely the EHC profile (i.e. the EHC in function of the SoC), the battery specific heat $C_p$, and the convective heat exchange coefficient $h_{conv}$ of the battery.

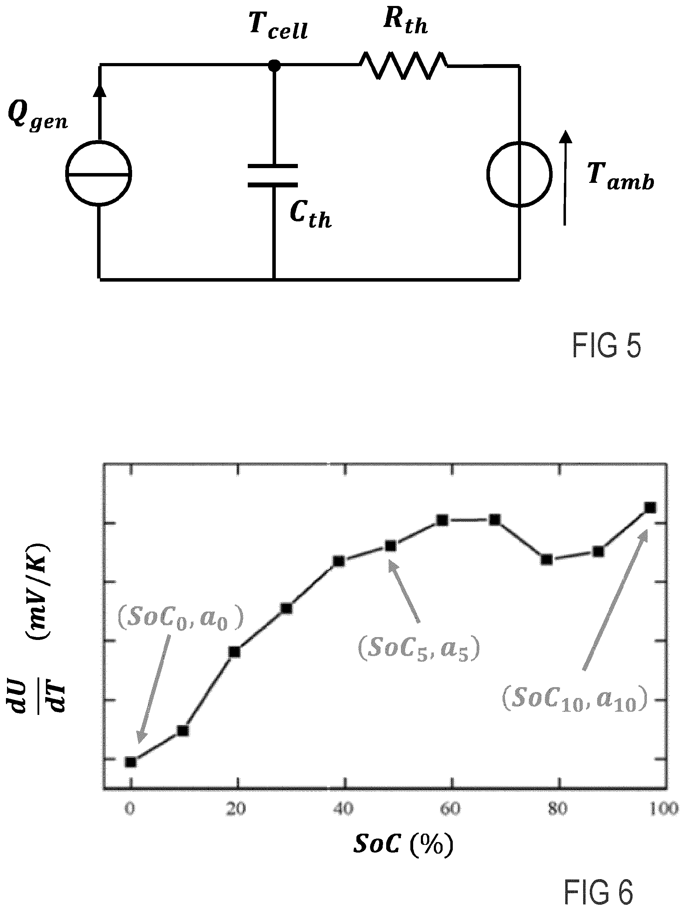

The battery thermal model is illustrated in Fig. 5. It is a battery equivalent circuit model comprising a heat source $H_{gen}$ representing the heat generated by the battery during said charge and discharge cycle, a thermal capacitor $C_{th}$ connected in parallel with the heat source $H_{gen}$ and representing a battery heat capacity, a source of thermal energy $T_{amb}$ connected in parallel with the heat source $H_{gen}$ and the thermal capacitor $C_{th}$ and representing the ambient temperature ("$T_{amb}$" will be used therefore to simply refer to the ambient temperature) of the environment surrounding the battery, and a thermal resistance $R_{th}$ connecting the thermal capacitor $C_{th}$ to the source of thermal energy $T_{amb}$ and representing convective heat exchange between the battery and its surrounding environment. Finally, $T_{cell}$ is the temperature of the battery.

The total heat generated $H_{gen}$ by the battery comprises the irreversible heat $Q_{irrev}$ related to the battery impedance and the reversible heat $Q_{rev}$ due to the entropic effect as expressed in Eq. 1. For the battery thermal model, the total heat generated is expressed by:

$$H_{gen} = C_{th} \cdot \frac{dT_{cell}}{dt} + \frac{T_{cell} + T_{amb}}{R_{th}} \qquad \text{Eq. } 4$$

The irreversible heat is obtained via Eq. 2, i.e. $Q_{irrev} = I \cdot (U_{oc} - U_{batt})$, where I and $U_{batt}$ are respectively the current and voltage of the battery measured in operation (in function of the time), and $U_{oc}$ is its open circuit voltage (also in function of the time).

The thermal capacitor $C_{th}$ and the thermal resistance $R_{th}$ are respectively given by the following equations:

$$C_{th} = m \cdot C_p \quad \text{Eq. } 5$$

$$R_{th} = \frac{1}{S_{conv} \cdot h_{conv}} \qquad \text{Eq. } 6$$

where m is the battery mass, and $S_{conv}$ is the battery convective heat exchange surface.

From equations (2) to (6), equation (1) can be rewritten as:

$$m \cdot C_p \cdot \frac{dT_{cell}}{dt} + S_{conv} \cdot h_{conv} \cdot (T_{cell} + T_{amb}) =$$

$$I \cdot (U_{OC} - U_{batt}) + I \cdot T_{cell} \cdot \frac{dU_{oc}}{dT_{cell}} \quad \text{Eq. } 7$$

The OCV $U_{oc}$, the current I, the battery voltage $U_{batt}$, the battery temperature $T_{cell}$ are the so-called "acquired data" that are thus measured input data, the mass m, the battery convective heat exchange surface $S_{conv}$, and, if constant, the ambient temperature $T_{amb}$ are also known fixed parameters. Optionally, the ambient temperature might be data measured in function of the time, and thus part of the "acquired data" used as input data in Eq. 7. Therefore, the only unknown parameters in Eq. 7 are the battery specific heat $C_p$, the convective heat exchange coefficient $h_{conv}$, and the EHC, i.e. the rate of change $dU_{oc}/dT_{cell}$, wherein the latter is typically a profile over SoC as represented in Fig. 1.

The present invention proposes to represent the EHC as a function f of N+1 parameters $a_0, ..., a_N$ taking real values:

$$\frac{dU_{oc}}{dT_{cell}} = f(a_0, ..., a_N) \qquad \text{Eq. } 8$$

For determining said EHC as a function of the SoC, the identification algorithm is configured for determining the value of each real parameter $a_0, ..., a_N$, by minimizing a difference between an estimated battery temperature (hereafter $T_{cell}^{est}$) and said measured temperature (hereafter $T_{cell}^{mea}$) that is part of the acquired data, wherein $T_{cell}^{est}$ is obtained by modeling, with said battery thermal model, the heat generated by the battery during the charge and discharge cycle. In other words, minimizing the difference between the experimentally measured temperature of the battery, i.e. $T_{cell}^{mea}$, and the estimated temperature $T_{cell}^{est}$ modelled by Eq. 7 wherein the EHC has been replaced by the expression given by Eq. 8, i.e. f($a_0$,..,$a_N$), all unknown might be automatically determined by the identification algorithm. Preferentially, the function f is a polynomial function of the SoC of order N, i.e. $dU_{oc}/dT_{cell}$ = $a_0$+$a_1$·SoC + $a_2$·SoC$^2$ + ... + $a_N$·SoC$^N$, with $a_0$, ... , $a_N$ being real parameters of the N$^{th}$ order polynomial function. According to another embodiment illustrated by Fig. 6, the function f might define, for each state of charge SoC$_i$ of a set S of discrete values of SoCs, S = {SoC$_0$,...SoC$_N$}, a corresponding value $a_i$ of the entropic coefficient. In other words, f is configured for associating to each SoC$_i$ of said set S, a corresponding entropic coefficient $a_i$, with i=0,...,N (with N=10 in the example provided by Fig. 6). Each of the SoC$_i$ might be a pre-fixed value, e.g. SoC$_0$ = 0%, SoC$_1$ = 10%, SOC$_N$ = 100%.

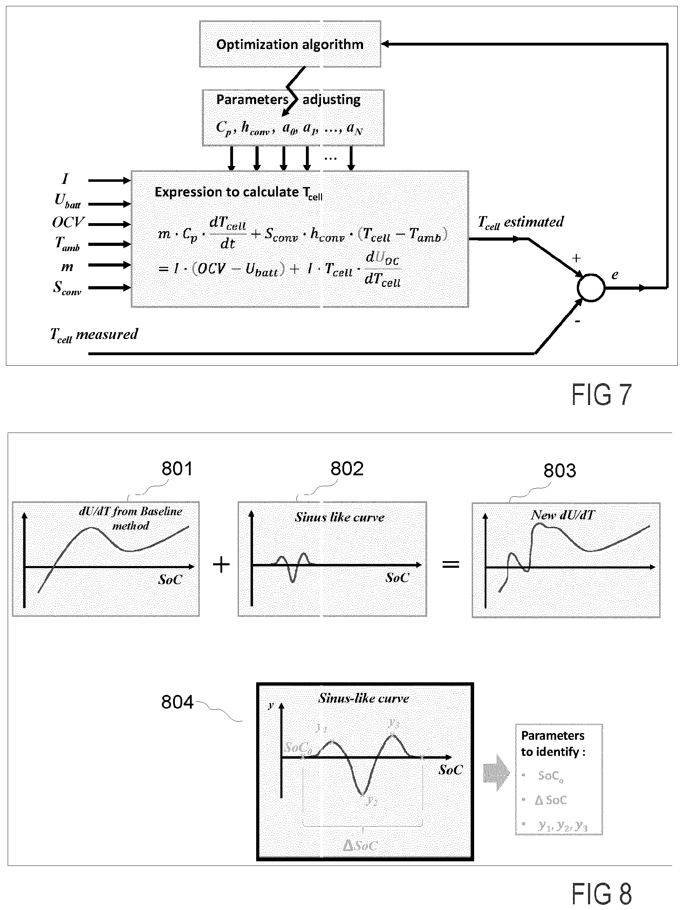

Given the expression of Eq. 8, the unknown parameters of Eq. 7 are thus the battery specific heat $C_p$, the convective heat exchange coefficient $h_{conv}$, and the series $a_0$,...,$a_N$. These unknown parameters are all real value parameters. Preferentially, the identification algorithm is configured for using a first optimization method or algorithm, such as a least square fitting algorithm, for identifying or determining said unknown parameters by minimizing the error ($\varepsilon$) (i.e. the difference) between the estimated battery temperature $T_{cell}^{est}$ provided through Eq. 7 and the measured battery temperature $T_{cell}^{mea}$ received as input within said acquired data. The identification algorithm according to the invention is schematically represented in Figure 7, wherein the identification algorithm uses the OCV (i.e. $U_{oc}$), the current I, the battery voltage $U_{batt}$, the ambient temperature $T_{amb}$, the mass m and the battery convective heat exchange surface $S_{conv}$ as input to Eq. 7 in order to estimate the battery temperature $T_{cell}^{est}$ while minimizing the difference ($\varepsilon$) with measured battery temperature $T_{cell}^{mea}$ via a first optimization algorithm that is configured for automatically adjusting the values of $C_p$, $h_{conv}$, and $a_0$, ... , $a_N$ so that the difference be minimal.

At step 250, notably at the end of said optimization, the identification algorithm outputs, notably via the third interface 113, at least the values of $a_0$,...,$a_N$. and optionally, also the values of $C_p$ and $h_{conv}$, for which the difference between $T_{cell}^{est}$ and $T_{cell}^{mea}$ was minimal. In other words, the processing unit 117 is configured for outputting, via its identification algorithm, the EHC as function of the SoCs of the battery according to Eq. 8: EHC = f($a_0$,...,$a_N$). Preferentially, said EHC might be displayed via said third interface 113.

In particular, the obtained EHC, and preferably $C_p$ and $h_{conv}$, might be stored in the memory 116 of the system 110. Preferentially, the system 110 according to the invention further comprises, or is configured for cooperating with, a thermal management system of the battery. The latter is configured for controlling, in function of the obtained EHC, a charge and/or a discharge of the battery, notably in function of the battery temperature. For instance, at step 250, the EHC as function of the SoC is used as input in said battery thermal management system of the battery. Using said EHC as function of the SoC, the thermal management system is configured for controlling the current and/or voltage applied to the battery during charging and/or discharging phases. Preferentially, the processing unit might be configured for automatically sending the obtained EHC to said battery thermal management system, enabling therefore to optimize the charging and/or discharging of the battery by said thermal management system.

Preferentially, the method according to the invention comprises an additional step, namely step 240, that follows step 230 and enables to further optimize the values of $a_0$,...,$a_N$, $C_p$, and $h_{conv}$ that minimize the difference between $T_{cell}^{est}$ and $T_{cell}^{mea}$. More precisely, the processing unit 117 comprises preferentially additional instructions, which, when executed by the processor, are configured, at step 240, for adding a sinus-like curve, that represents a variation of EHC values in function of the SoC, to the EHC as function of the SoC obtained at the end of step 230. Preferentially, the sinus-like curve is defined by a set S1 of fitting parameters having real values. Adding said sinus-like curve to the EHC obtained at the end of step 230 enables to create a new EHC in function of the SoC that can be then used as new input to said identification algorithm. The latter is then configured for using a second optimization method or algorithm, such as a least square fitting algorithm, for identifying or determining said fitting parameters of the sinus-like curve by minimizing the error ($\varepsilon$) (i.e. the difference) between the estimated battery temperature $T_{cell}^{est}$ and the measured battery temperature $T_{cell}^{mea}$. The second optimization algorithm may use the same optimization technique as the first optimization algorithm, like said least square fitting, and is thus configured for optimizing the values of the fitting real parameters of said set S1 by minimizing said difference between the estimated battery temperature $T_{cell}^{est}$ and said measured temperature $T_{cell}^{mea}$. At the end of said additional optimization, step 250 takes place again, wherein the identification algorithm is configured for outputting, notably via said third interface 113, said EHC in function of the SoC as being the new EHC obtained with the optimized values of the fitting parameters of the sinus-like curve.

A schematic illustration of the step 240 is presented in Figure 8, wherein a new EHC 803 is obtained by adding a sinus-like curve 802 to the previously obtained EHC 801. This enables to capture an oscillation (for instance a presence of an intermediate minimum value and of an intermediate maximum value of the EHC between the minimum value at SoC = 0% and the maximum value at SoC = 100%) of the entropic coefficient that takes place with respect to an interval of values of the SoC, e.g. for 30% < SoC < 60%. The sinus-like curve can thus be used for performing a second fit with the identified entropic coefficient values obtained at the end of step 230.

Preferentially, said sinus-like curve is a cubic spline defined by 5 real parameters, namely $SoC_0$, $DSoC$, $y_1$, $y_2$, $y_3$ (see graphic 804 in Figure 8), wherein said cubic spline takes value from an interval $[SoC_0; SoC_0 + \Delta SoC]$ and maps them to real numbers representing EHC values, and comprises two maxima among said EHC values, namely $y_1$ and $y_3$, and one EHC minimum value, namely $y_2$. Said cubic spline passes for instance through the set of points $\{(SoC_0,0),(x_1,y_1),(x_2,y_2),(x_3,y_3), (SoC_0+\Delta SoC,0)\}$, with $SoC_0 < x_1 < x_2 < x_3 < SoC_0+\Delta SoC$, and wherein the distance along the X-axis between any two adjacent points of said set is preferably a constant. Said second optimization of the identification algorithm enables to identify or determine said 5 real fitting parameters $SoC_0$, $\Delta SoC$, $y_1$, $y_2$, $y_3$ that minimize the difference between $T_{cell}^{est}$ and $T_{cell}^{mea}$.

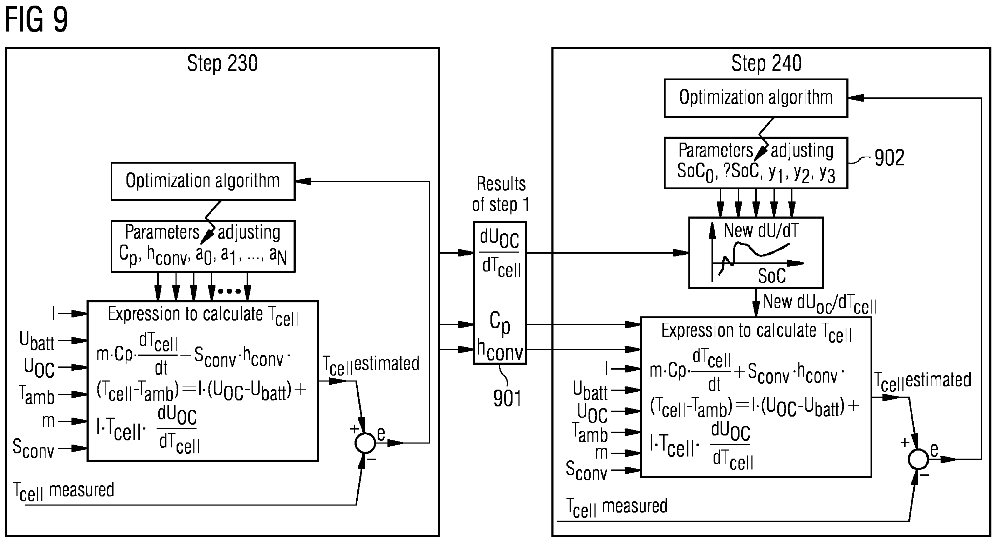

Figure 9 better illustrates the method according to the invention when comprising the steps 230 and 240. At the end of step 230, the identification algorithm preferentially outputs the determined EHC in function of SoC, i.e. $f(a_0,...,a_N)$ and the values obtained for $C_p$ and $h_{conv}$ for which the difference between $T_{cell}^{est}$ and $T_{cell}^{mea}$ was minimal. Then, in particular instead of outputting them via the third interface notably for displaying them, the identification algorithm might be configured for further running said step 240 in which the previously outputted data (i.e. $f(a_0,...,a_N)$, $C_p$, and $h_{conv}$) are used as new inputs 901 for a second fitting procedure implemented by said identification algorithm. In said second fitting procedure, the EHC = $dU_{oc}/dT_{cell}$ = $f(a_0,...,a_N)$ received as new input is modified by adding said sinus-like curve $g(SoC)$ in order to create a new EHC in function of SoC (e.g. $EHC^{new}(SoC) = f(a_0,...,a_N,SOC) + g(SoC)$), which, together with $C_p$ and $h_{conv}$, is used in Eq. 7 configured for estimating the battery temperature, wherein the unknown parameters 902 that need to be adjusted are this time the fitting parameters of the sinus-like curve, i.e. $SoC_0$, $\Delta SoC$, $y_1$, $y_2$, $y_3$. The second optimization algorithm determines the value of each of said fitting parameters that minimizes the difference (or error ε) between $T_{cell}^{est}$ and $T_{cell}^{mea}$, and at the end, outputs the values of $SoC_0$, $\Delta SoC$, $y_1$, $y_2$, $y_3$ for which said difference was minimal. In fact, the second optimization algorithm is configured for finding the best interval $[SoC_0; SoC_0 + \Delta SoC]$ for inserting or adding said sinus-like curve into the previously obtained EHC so that said difference or error be minimized. At the end, the identification algorithm outputs, for instance via said third interface 113, the new EHC, i.e. $EHC^{new}$, as defined by the parameters $a_0, ...,$ $a_N$, $C_p$, $h_{conv}$, $SoC_0$, $\Delta SoC$, $y_1$, $y_2$, $y_3$ that minimized said difference between $T_{cell}^{est}$ and $T_{cell}^{mea}$ at the end of step 240.

Said new EHC might be then used by the thermal management system of the battery for controlling, in function of said new EHC, a charge or discharge of the battery.

Preferentially, the system according to the invention may use a battery electrical model for estimating said battery voltage $U_{batt}$ in function of the time that is then used as input in said identification algorithm in step 230. In this case, the battery voltage measuring is not necessary, notably when using an accurate battery electric model to estimate the battery voltage.

In order to further improve the precision of the new EHC estimated by the identification algorithm, the latter may repeat step 240 several times, using each time a previously obtained "new EHC" that has been outputted at the end of step 240 as an inputted EHC when newly repeating said step 240 (i.e., when starting again step 240). This allows to add several sinus-like curves to the EHC obtained at the end of step 230. In such a case, the results of a previous iteration (i.e. $a_0,...,a_N$, $C_p$, $h_{conv}$, $SoC_0$, $\Delta SoC$, $y_1$, $y_2$, $y_3$ as obtained at the end of step 240) are used as input for a directly next iteration, adding therefore to the EHC curve defined by $a_0,...,a_N$, $SoC_0$, $\Delta SoC$, $y_1$, $y_2$, $y_3$ a new sinus-like curve, and performing then again step 240.

In conclusion, the present invention advantageously provides a new system and method for estimating the EHC of a battery. Compared to existing methods, the present invention provides several advantages:

- the determination of the EHC is faster than other existing methods. It typically takes approx. 5 hours for determining the EHC with the proposed method when a 1C rate charge and discharge current is used, against ~190 hours for the potentiometric method, ~20 hours for a continuous curve of the calorimetric method, and ~16 hours for the frequency analysis method;
- it requires less experimental effort (e.g., no need of specific equipment such as calorimeter and electrochemical impedance spectroscopy (EIS), no need of additional thermal isolation of the battery under test, etc.;
- it gives accurate results compared to the literature;

- it is suitable for "in-situ" applications. For example, the system might be used for estimating the EHC of a battery pack in a vehicle, since the voltage, current and temperature are measurable for each battery cell inside the pack. Additionally, the proposed method can be used by a battery management system (BMS) to identify the entropic coefficient of the battery cells during the charging phase of the battery pack. Since the entropic coefficient profile changes when a battery cell ages, the estimated entropic coefficient of each cell can be used to monitor the state of health of the battery pack. Additionally, the system according to the invention may automatically detect a potential defective or less efficient cell of a pack by comparing the entropic coefficients obtained for each cell and identifying a difference (e.g. EHC value at a given SoC, or a shift of an EHC curve with respect to another one) between one of said entropic coefficients and the other entropic coefficient(s).

**Claims**

1. Method (200) for automatically determining an entropic heat coefficient, hereafter "EHC", of a battery (120), the method comprising:

   a) receiving or acquiring (210), for said battery (120), a current, voltage, and temperature of the battery (120) in function of the time, wherein said current, voltage and temperature have been measured simultaneously during a constant charge and discharge cycle;
   b) receiving or acquiring (220) an open-circuit voltage, hereafter "OCV", of the battery as a function of its state-of-charge, hereafter "SoC";
   c) feeding (230) said current, voltage and temperature in function of the time and said OCV in function of the SoC in an identification algorithm based on a battery thermal model, said identification algorithm being configured for determining said EHC as a function of the SoC, wherein, for said determination, the EHC is defined as a function of N+1 real parameters $a_0,...,a_N$, wherein the identification algorithm is configured for determining the value of each real parameter $a_0,...,a_N$, by minimizing a difference between an estimated battery temperature and said measured temperature, wherein the estimated battery temperature is obtained by modeling, with said battery thermal model, a heat generated by the battery during said charge and discharge cycle;
   d) outputting (250), by said identification algorithm, the determined EHC as function of the SoC.

2. The method (200) according to claim 1, wherein said constant charge and discharge cycle comprises:

   - a discharge phase during which the fully charged battery is discharged at constant current until its cut-off voltage.

3. The method (200) according to claim 1 or 2, wherein said constant charge and discharge cycle comprises:

   - a charge phase during which the battery (120) is charged at a constant current until its maximal voltage is reached.

4. The method (200) according to claim 3, wherein the charge phase comprises, after reaching said battery maximal voltage, a charge at constant voltage until the battery current decreases to a predefined level.

5. The method (200) according to one of the claims 1 to 4, wherein the battery thermal model is a battery equivalent circuit model comprising a heat source $H_{gen}$ representing the heat generated by the battery (120) during said charge and discharge cycle, a thermal capacitor $C_{th}$ connected in parallel with the heat source $H_{gen}$ and representing a battery heat capacity, a source of thermal energy $T_{amb}$ connected in parallel with the heat source $H_{gen}$ and the thermal capacitor $C_{th}$ and representing the ambient temperature of the environment surrounding the battery, and a thermal resistance $R_{th}$ connecting the thermal capacitor $C_{th}$ to the source of thermal energy $T_{amb}$ and representing convective heat exchange between the battery (120) and its surrounding environment.

6. The method (200) according to one of the claims 1 to 5, wherein a sinus-like curve (802) of the EHC in function of the SoC is added (240) to the determined EHC (801) as function of the SoC in order to create a new EHC (803) in function of the SoC, wherein said sinus-like curve (801) is defined by a set of fitting real parameters, wherein said new EHC (803) is used as a new input to the identification algorithm which is further configured for optimizing the values of the fitting real parameters of said set by minimizing said difference between the estimated battery temperature and said measured temperature, the identification algorithm being then configured for outputting said EHC in function of the SoC as being the new EHC as obtained with the optimized values of the fitting real parameters.

7. The method (200) according to claim 6, wherein said sinus-like curve (802) is a cubic spline defined by 5 real parameters, namely $SoC_0$, $\Delta SoC$, $y_1$, $y_2$, $y_3$, wherein said cubic spline takes value from an interval $[SoC_0; SoC_0 + \Delta SoC]$ and maps them to real numbers, and comprises two maxima, namely $y_1$ and $y_3$, and one minimum, namely $y_2$.

8. The method (200) according to one of the claims 1 to 7, wherein the EHC as function of the SoC is used as input in a thermal management system of the battery (120) configured for controlling, in function of said EHC, a charge or discharge of the battery (120) in function of the battery temperature.

9. A system (110) configured for automatically determining an entropic heat coefficient, hereafter "EHC", of a battery (120), said system (110) comprising:

- a first interface (111) configured for receiving or acquiring (210), for said battery (120), a current, voltage, and temperature of the battery (120) in function of the time, wherein said current, voltage and temperature have been measured simultaneously during a constant charge and discharge cycle;
- a second interface (112) configured for receiving or acquiring (220) an open-circuit voltage, hereafter "OCV", of the battery as a function of its state-of-charge, hereafter "SoC"
- a memory (116) for storing the OCV, current, voltage, and temperature acquired via the first and second interfaces;
- a processing unit (117) comprising at least one processor and one or more processor-executable instructions stored on at least one computer-readable storage medium of the system (110), wherein said processor-executable instructions comprise instructions that, when executed by said processor:

- feed (230) said current, voltage and temperature in function of the time and said OCV in function of the SoC in an identification algorithm based on a battery thermal model;
- execute said identification algorithm, the latter being configured for determining said EHC as a function of the SoC, wherein, for said determination, the EHC is defined as a function of N+1 parameters $a_0,...,a_N$ taking real values, wherein the identification algorithm is configured for determining the value of each real parameter $a_0,...,a_N$, by minimizing a difference between an estimated battery temperature and said measured temperature, wherein the estimated battery temperature is obtained by modeling, with said battery thermal model, a heat generated by the battery during said charge and discharge cycle;
- output (250), via a third interface (113), the EHC as function of the SoC as determined by the identification algorithm;

- said third interface (113) notably configured for displaying the determined EHC.

10. System (110) according to claim 9, comprising a charging device connected to the first interface (111), configured for implementing said constant charge and discharge cycle performed at ambient temperature and for acquiring said current, voltage, and temperature of the battery (120) in function of the time.

11. System (110) according to claim 9 or 10, wherein said processor-executable instructions comprise further instructions that, when executed by said processor:

- add (240) a sinus-like curve (802) of EHC in function of the SoC to the previously determined EHC (801) as function of the SoC in order to create a new EHC (803) in function of the SoC, wherein said sinus-like curve (802) is defined by a set of fitting real parameters;
- feed the identification algorithm with said new EHC (803), wherein said identification algorithm is further configured for optimizing the values of the fitting real parameters of said set by minimizing said difference between the estimated battery temperature and said measured temperature;
- run or execute said identification algorithm, which, upon execution, is configured for outputting said new EHC (803) as obtained with the optimized values of the fitting real parameters;

wherein the EHC outputted by said third interface is said new EHC obtained with the optimized values of the fitting real parameters.

12. System (110) according to one of the claims 9 to 11, comprising a thermal management system of the battery (120), connected to said third interface (113) for acquiring said EHC in function of the SoC, and configured for controlling, in function of said EHC, a charge or discharge of the battery (120) in function of its temperature.

13. A non-transitory machine-readable medium storing instructions executable by a processing unit (117) to cause a computing system to:

   a) receive or acquire (210) a current, voltage, and temperature of a battery (120) in function of the time, wherein said current, voltage and temperature have been measured simultaneously during a constant charge and discharge cycle;
   b) receive or acquire (220) an open-circuit voltage, hereafter "OCV", of the battery as a function of its state-of-charge, hereafter "SoC";
   c) feed (230) said current, voltage and temperature in function of the time and said OCV in function of the SoC in an identification algorithm based on a battery thermal model;
   d) execute said identification algorithm, the latter being configured for determining said EHC as a function of the SoC, wherein, for said determination, the EHC is defined as a function of N+1 real parameters $a_0,...,a_N$, wherein the identification algorithm is configured for determining the value of each real parameter $a_0,...,a_N$, by minimizing a difference between an estimated battery temperature and said measured temperature, wherein the estimated battery temperature is obtained by modeling, with said battery thermal model, a heat generated by the battery (120) during said charge and discharge cycle;
   e) output (240) the EHC as function of the SoC as determined by the identification algorithm.

14. Non-transitory machine-readable medium according to claim 13, further storing instructions executable by said processing unit (117) to cause the computing system to:

   - add (240) a sinus-like curve of EHC in function of the SoC to the previously determined EHC as function of the SoC in order to create a new EHC in function of the SoC, wherein said sinus-like curve is defined by a set of fitting real parameters,
   - feed the identification algorithm with said new EHC, wherein said identification algorithm is further configured for optimizing the values of the fitting real parameters of said set by minimizing said difference between the estimated battery temperature and said measured temperature;
   - run or execute said identification algorithm, which, upon execution, is configured for outputting said new EHC with the optimized values of the fitting real parameters;

   wherein the outputted EHC in function of the SoC is said new EHC as obtained with the optimized values of the fitting real parameters.

15. Non-transitory machine-readable medium according to claim 13 or 14, further storing instructions executable by said processing unit (117) to cause the computing system to:

   - implement a thermal management of the battery in function of the determined EHC in function of the SoC, wherein said thermal management of the battery is configured for controlling, in function of said EHC, a charge or discharge of the battery in function of its temperature.

## Patentansprüche

1. Verfahren (200) zum automatischen Bestimmen eines Entropiekoeffizienten einer Batterie (120), nachfolgend "EHC" genannt, das Folgendes umfasst:

   a) Empfangen oder Erfassen (210) eines Stroms, einer Spannung und einer Temperatur der Batterie (120) für die Batterie (120) in Abhängigkeit von der Zeit, wobei der Strom, die Spannung und die Temperatur bei einem konstanten Lade- und Entladezyklus gleichzeitig gemessen wurden,
   b) Empfangen oder Erfassen (220) einer Ruhespannung der Batterie, nachfolgend "OCV" genannt, in Abhängigkeit von deren Ladezustand, nachfolgend "SoC" genannt,
   c) Einspeisen (230) des Stroms, der Spannung und der Temperatur in Abhängigkeit von der Zeit und der OCV in Abhängigkeit vom SoC in einen auf einem thermischen Batteriemodell basierenden Erkennungsalgorithmus, wobei der Erkennungsalgorithmus zum Bestimmen des EHC als Funktion des SoC konfiguriert ist, wobei der EHC für die Bestimmung als Funktion von N+1 reellen Parametern $a_0, ... , a_N$ definiert ist, wobei der Erkennungsalgorithmus zum Bestimmen des Werts jedes reellen Parameters $a_0, ... , a_N$ durch Minimieren einer Differenz zwischen einer geschätzten Batterietemperatur und der gemessenen Temperatur konfiguriert ist, wobei die geschätzte Batterietemperatur durch Modellieren einer von der Batterie im Verlauf des Lade- und Entladezyklus erzeugten Wärme mit dem thermischen Batteriemodell erhalten wird,
d) Ausgeben (250) des bestimmten EHC als Funktion des SoC durch den Erkennungsalgorithmus.

2. Verfahren (200) nach Anspruch 1, wobei der konstante Lade- und Entladezyklus Folgendes umfasst:

   - eine Entladephase, bei der die vollständig aufgeladene Batterie bei einem konstanten Strom bis auf ihre Entladeschlussspannung entladen wird.

3. Verfahren (200) nach Anspruch 1 oder 2, wobei der konstante Lade- und Entladezyklus Folgendes umfasst:

   - eine Ladephase, bei der die Batterie (120) bei einem konstanten Strom geladen wird, bis ihre maximale Spannung erreicht ist.

4. Verfahren (200) nach Anspruch 3, wobei die Ladephase, wenn die maximale Batteriespannung erreicht ist, ein Laden bei einer konstanten Spannung umfasst, bis der Batteriestrom auf einen vorgegebenen Pegel sinkt.

5. Verfahren (200) nach einem der Ansprüche 1 bis 4, wobei es sich bei dem thermischen Batteriemodell um ein einer Batterie entsprechendes Stromkreismodell handelt, das Folgendes umfasst: eine Wärmequelle $H_{gen}$, die die von der Batterie (120) im Verlauf des Lade- und Entladezyklus erzeugte Wärme repräsentiert, einen thermischen Kondensator $C_{th}$, der mit der Wärmequelle $H_{gen}$ parallelgeschaltet ist und eine Wärmekapazität der Batterie repräsentiert, eine Quelle für Wärmeenergie $T_{amb}$, die mit der Wärmequelle $H_{gen}$ und dem thermischen Kondensator $C_{th}$ parallelgeschaltet ist und die Umgebungstemperatur in der Umgebung der Batterie repräsentiert, und einen Wärmewiderstand $R_{th}$, der den thermischen Kondensator $C_{th}$ mit der Quelle für Wärmeenergie $T_{amb}$ verbindet und einen Konvektionswärmeaustausch zwischen der Batterie (120) und deren Umgebung repräsentiert.

6. Verfahren (200) nach einem der Ansprüche 1 bis 5, wobei eine sinusartige Kurve (802) des EHC in Abhängigkeit vom SoC zu dem bestimmten EHC (801) als Funktion des SoC hinzugefügt (240) wird, um einen neuen EHC (803) in Abhängigkeit vom SoC zu erzeugen, wobei die sinusartige Kurve (801) von einer Reihe passender reeller Parameter definiert wird, wobei der neue EHC (803) als neuer Eingabewert für den Erkennungsalgorithmus verwendet wird, der ferner zum Optimieren der passenden reellen Parameter aus der Reihe durch Minimieren der Differenz zwischen der geschätzten Batterietemperatur und der gemessenen Temperatur konfiguriert ist, wobei der Erkennungsalgorithmus dann zum Ausgeben des EHC in Abhängigkeit vom SoC als neuem EHC konfiguriert wird, der mit den optimierten Werten für die passenden reellen Parameter erhalten wird.

7. Verfahren (200) nach Anspruch 6, wobei es sich bei der sinusartigen Kurve (802) um einen kubischen Spline handelt, der durch 5 reelle Parameter, und zwar $SoC_0$, $\Delta SoC$, $y_1$, $y_2$, $y_3$, definiert wird, wobei der kubische Spline Werte aus einem Intervall $[SoC_0; SoC_0 + \Delta SoC]$ nimmt und reellen Zahlen zuordnet und zwei Maxima, und zwar $y_1$ und $y_3$, und ein Minimum, und zwar $y_2$, umfasst.

8. Verfahren (200) nach einem der Ansprüche 1 bis 7, wobei der EHC als Funktion des SoC als Eingabewert für ein Thermomanagementsystem der Batterie (120) verwendet wird, das in Abhängigkeit vom EHC ein Laden oder Entladen der Batterie (120) in Abhängigkeit von der Batterietemperatur regelt.

9. System (110), das zum automatischen Bestimmen eines Entropiekoeffizienten einer Batterie (120), nachfolgend "EHC" genannt, konfiguriert ist und Folgendes umfasst:

   - eine erste Schnittstelle (111), die zum Empfangen oder Erfassen (210) eines Stroms, einer Spannung und einer Temperatur der Batterie (120) für die Batterie (120) in Abhängigkeit von der Zeit konfiguriert ist, wobei der Strom, die Spannung und die Temperatur bei einem konstanten Lade- und Entladezyklus gleichzeitig gemessen wurden,
   - eine zweite Schnittstelle (112), die zum Empfangen oder Erfassen (220) einer Ruhespannung der Batterie, nachfolgend "OCV" genannt, in Abhängigkeit von deren Ladezustand, nachfolgend "SoC" genannt, konfiguriert ist,
   - einen Speicher (116) zum Speichern der OCV, des Stroms, der Spannung und der Temperatur, die über die erste und die zweite Schnittstelle abgerufen wurden,
   - eine Verarbeitungseinheit (117), die mindestens einen Prozessor und eine oder mehrere per Prozessor ausführbare Anweisungen umfasst, die auf mindestens einem computerlesbaren Speichermedium des Systems (110) gespeichert sind, wobei zu den per Prozessor ausführbaren Anweisungen Anweisungen gehören, die, wenn sie von dem Prozessor ausgeführt werden:

- den Strom, die Spannung und die Temperatur in Abhängigkeit von der Zeit und die OCV in Abhängigkeit vom SoC in einen auf einem thermischen Batteriemodell basierenden Erkennungsalgorithmus einspeisen (230),
- den Erkennungsalgorithmus ausführen, der zum Bestimmen des EHC als Funktion des SoC konfiguriert ist, wobei der EHC für die Bestimmung als Funktion von N+1 Parametern $a_0, \ldots, a_N$ bei Annahme von reellen Werten definiert ist, wobei der Erkennungsalgorithmus zum Bestimmen des Werts jedes reellen Parameters $a_0, \ldots, a_N$ durch Minimieren einer Differenz zwischen einer geschätzten Batterietemperatur und der gemessenen Temperatur konfiguriert ist, wobei die geschätzte Batterietemperatur durch Modellieren einer von der Batterie im Verlauf des Lade- und Entladezyklus erzeugten Wärme mit dem thermischen Batteriemodell erhalten wird,
- über eine dritte Schnittstelle (113) den vom Erkennungsalgorithmus bestimmten EHC als Funktion des SoC ausgeben (250).

- wobei die dritte Schnittstelle (113) insbesondere zum Anzeigen des bestimmten EHC konfiguriert ist.

10. System (110) nach Anspruch 9, das ein Ladegerät umfasst, das mit der ersten Schnittstelle (111) verbunden und so konfiguriert ist, dass es den konstanten Lade- und Entladezyklus umsetzt, der bei Umgebungstemperatur durchgeführt wird, und den Strom, die Spannung und die Temperatur der Batterie (120) in Abhängigkeit von der Zeit erfasst.

11. System (110) nach Anspruch 9 oder 10, wobei die per Prozessor ausführbaren Anweisungen ferner Anweisungen umfassen, die, wenn sie von dem Prozessor ausgeführt werden:

- eine sinusartige Kurve (802) des EHC in Abhängigkeit vom SoC zu dem bereits bestimmten EHC (801) als Funktion des SoC hinzufügen (240), um einen neuen EHC (803) in Abhängigkeit vom SoC zu erzeugen, wobei die sinusartige Kurve (801) durch eine Reihe passender reeller Parameter definiert ist,
- den neuen EHC (803) in den Erkennungsalgorithmus einspeisen, wobei der Erkennungsalgorithmus ferner zum Optimieren der Werte der passenden reellen Parameter aus der Reihe durch Minimieren der Differenz zwischen der geschätzten Batterietemperatur und der gemessenen Temperatur konfiguriert ist,
- den Erkennungsalgorithmus ausführen, der so konfiguriert ist, dass er bei Ausführung den neuen EHC (803) ausgibt, der mit den optimierten Werten für die passenden reellen Parameter erhalten wird,

wobei es sich bei dem von der dritten Schnittstelle ausgegebenen EHC um den neuen EHC handelt, der mit den optimierten Werten für die passenden reellen Parameter erhalten wird.

12. System (110) nach einem der Ansprüche 9 bis 11, das ein Thermomanagementsystem für die Batterie (120) umfasst, das zum Erfassen des EHC in Abhängigkeit vom SoC mit der dritten Schnittstelle (113) verbunden und so konfiguriert ist, dass es in Abhängigkeit vom EHC ein Laden oder Entladen der Batterie (120) in Abhängigkeit von deren Temperatur regelt.

13. Nichtflüchtiges, maschinenlesbares Medium, auf dem Anweisungen gespeichert sind, die von einer Verarbeitungseinheit (117) ausführbar sind und ein Rechensystem dazu veranlassen:

a) einen Strom, eine Spannung und eine Temperatur einer Batterie (120) in Abhängigkeit von der Zeit zu empfangen oder zu erfassen (210), wobei der Strom, die Spannung und die Temperatur bei einem konstanten Lade- und Entladezyklus gleichzeitig gemessen wurden,
b) eine Ruhespannung der Batterie, nachfolgend "OCV" genannt, in Abhängigkeit von deren Ladezustand, nachfolgend "SoC" genannt, zu empfangen oder zu erfassen (220),
c) den Strom, die Spannung und die Temperatur in Abhängigkeit von der Zeit und die OCV in Abhängigkeit vom SoC in einen auf einem thermischen Batteriemodell basierenden Erkennungsalgorithmus einzuspeisen (230),
d) den Erkennungsalgorithmus auszuführen, der zum Bestimmen des EHC als Funktion des SoC konfiguriert ist, wobei der EHC für die Bestimmung als Funktion von N+1 reellen Parametern $a_0, \ldots, a_N$ definiert ist, wobei der Erkennungsalgorithmus zum Bestimmen des Werts jedes reellen Parameters $a_0, \ldots, a_N$ durch Minimieren einer Differenz zwischen einer geschätzten Batterietemperatur und der gemessenen Temperatur konfiguriert ist, wobei die geschätzte Batterietemperatur durch Modellieren einer von der Batterie (120) im Verlauf des Lade- und Entladezyklus erzeugten Wärme mit dem thermischen Batteriemodell erhalten wird,
e) den vom Erkennungsalgorithmus bestimmten EHC als Funktion des SoC auszugeben (240).

**14.** Nichtflüchtiges, maschinenlesbares Medium nach Anspruch 13, auf dem ferner Anweisungen gespeichert sind, die von der Verarbeitungseinheit (117) ausführbar sind und das Rechensystem dazu veranlassen:

- eine sinusartige Kurve des EHC in Abhängigkeit vom SoC zu dem bereits bestimmten EHC als Funktion des SoC hinzuzufügen (240), um einen neuen EHC in Abhängigkeit vom SoC zu erzeugen, wobei die sinusartige Kurve durch eine Reihe passender reeller Parameter definiert ist,
- den neuen EHC in den Erkennungsalgorithmus einzuspeisen, wobei der Erkennungsalgorithmus ferner zum Optimieren der Werte der passenden reellen Parameter aus der Reihe durch Minimieren der Differenz zwischen der geschätzten Batterietemperatur und der gemessenen Temperatur konfiguriert ist,
- den Erkennungsalgorithmus auszuführen, der so konfiguriert ist, dass er bei Ausführung den neuen EHC mit den optimierten Werten für die passenden reellen Parameter ausgibt,

wobei es sich bei dem ausgegebenen EHC in Abhängigkeit vom SoC um den neuen EHC handelt, der mit den optimierten Werten für die passenden reellen Parameter erhalten wird.

**15.** Nichtflüchtiges, maschinenlesbares Medium nach Anspruch 13 oder 14, auf dem ferner Anweisungen gespeichert sind, die von der Verarbeitungseinheit (117) ausführbar sind und das Rechensystem dazu veranlassen:

- ein Thermomanagement der Batterie in Abhängigkeit von dem bestimmten EHC in Abhängigkeit vom SoC umzusetzen, wobei das Thermomanagement der Batterie so konfiguriert ist, dass es in Abhängigkeit vom EHC ein Laden oder Entladen der Batterie in Abhängigkeit von deren Temperatur regelt.

## Revendications

**1.** Procédé (200) de détermination automatique d'un coefficient thermique entropique, ci-après « EHC », d'une batterie (120), le procédé comprenant :

a) la réception ou l'acquisition (210), pour ladite batterie (120), d'un courant, d'une tension et d'une température de la batterie (120) en fonction du temps, dans lequel ledit courant, ladite tension et ladite température ont été mesurés simultanément pendant un cycle de recharge et de décharge constant ;
b) la réception ou l'acquisition (220) d'une tension en circuit ouvert, ci-après « OCV », de la batterie en fonction de son état de charge, ci-après « SoC » ;
c) la fourniture (230) dudit courant, de ladite tension et de ladite température en fonction du temps et ladite OCV en fonction du SoC à un algorithme d'identification basé sur un modèle thermique de batterie, ledit algorithme d'identification étant configuré pour déterminer ledit EHC en fonction du SoC, dans lequel, pour ladite détermination, l'EHC est défini en fonction de N+1 paramètres réels $a_0,...a_N$. dans lequel l'algorithme d'identification est configuré pour déterminer la valeur de chaque paramètre réel $a_0,...,a_N$, en minimisant une différence entre une température de batterie estimée et ladite température mesurée, dans lequel la température de batterie estimée est obtenue en modélisant, avec ledit modèle thermique de batterie, une chaleur générée par la batterie pendant ledit cycle de recharge et de décharge ;
d) la délivrance en sortie (250), par ledit algorithme d'identification, de l'EHC déterminé en fonction du SoC.

**2.** Procédé (200) selon la revendication 1, dans lequel ledit cycle de recharge et de décharge constant comprend :

- une phase de décharge pendant laquelle la batterie complètement rechargée est déchargée à courant constant jusqu'à sa tension de coupure.

**3.** Procédé (200) selon la revendication 1 ou 2, dans lequel ledit cycle de recharge et de décharge constant comprend :

- une phase de recharge pendant laquelle la batterie (120) est rechargée à courant constant jusqu'à ce que sa tension maximale soit atteinte.

**4.** Procédé (200) selon la revendication 3, dans lequel la phase de recharge comprend, après que ladite tension maximale de batterie a été atteinte, une recharge à tension constante jusqu'à ce que le courant de batterie diminue jusqu'à un niveau prédéfini.

**5.** Procédé (200) selon l'une des revendications 1 à 4, dans lequel le modèle thermique de batterie est un modèle circuit équivalent de batterie comprenant une source de chaleur $H_{gen}$ représentant la chaleur générée par la batterie (120) pendant ledit cycle de recharge et de décharge, un condensateur thermique $C_{th}$ connecté en parallèle avec la source de chaleur $H_{gen}$ et représentant une capacité thermique de batterie, une source d'énergie thermique $T_{amb}$ connectée en parallèle avec la source de chaleur $H_{gen}$ et le condensateur thermique $C_{th}$ et représentant la température ambiante du milieu entourant la batterie, et une résistance thermique $R_{th}$ connectant le condensateur thermique $C_{th}$ à la source d'énergie thermique $T_{amb}$ et représentant un échange de chaleur par convection entre la batterie (120) et son milieu environnant.

6. Procédé (200) selon l'une des revendications 1 à 5, dans lequel une courbe sinusoïdale (802) de l'EHC en fonction du SoC est ajoutée (240) à l'EHC déterminé (801) en fonction du SoC afin de créer un nouvel EHC (803) en fonction du SoC, dans lequel ladite courbe sinusoïdale (801) est définie par un ensemble de paramètres réels d'adaptation, dans lequel ledit nouvel EHC (803) est utilisé en tant que nouvelle entrée dans l'algorithme d'identification qui est en outre configuré pour optimiser les valeurs des paramètres réels d'adaptation dudit ensemble en minimisant ladite différence entre la température de batterie estimée et ladite température mesurée, l'algorithme d'identification étant ensuite configuré pour délivrer en sortie ledit EHC en fonction du SoC en tant que nouvel EHC tel qu'obtenu avec les valeurs optimisées des paramètres réels d'adaptation.

7. Procédé (200) selon la revendication 6, dans lequel ladite courbe sinusoïdale (802) est une spline cubique définie par 5 paramètres réels, à savoir $SoC_0$, $\Delta SoC$, $y_1$, $y_2$, $y_3$, dans lequel ladite spline cubique prend une valeur à partir d'un intervalle $[SoC_0 ; SoC_0+\Delta SoC]$ et les cartographie en des nombres réels, et comprend deux maxima, à savoir $y_1$ et $y_3$, et un minimum, à savoir $y_2$.

8. Procédé (200) selon l'une des revendications 1 à 7, dans lequel l'EHC en fonction du SoC est utilisé comme entrée dans un système de gestion thermique de la batterie (120) configuré pour commander, en fonction dudit EHC, une recharge ou une décharge de la batterie (120) en fonction de la température de batterie.

9. Système (110) configuré pour déterminer automatiquement un coefficient thermique entropique, ci-après « EHC », d'une batterie (120), ledit système (110) comprenant :

   - une première interface (111) configurée pour recevoir ou acquérir (210), pour ladite batterie (120), un courant, une tension et une température de la batterie (120) en fonction du temps, dans lequel ledit courant, ladite tension et ladite température ont été mesurés simultanément pendant un cycle de recharge et de décharge constant ;
   - une deuxième interface (112) configurée pour recevoir ou acquérir (220) une tension en circuit ouvert, ci-après « OCV », de la batterie en fonction de son état de charge, ci-après « SoC » ;
   - une mémoire (116) pour stocker l'OCV, le courant, la tension et la température acquis via les première et deuxième interfaces ;
   - une unité de traitement (117) comprenant au moins un processeur et une ou plusieurs instruction(s) exécutable(s) par un processeur stockée(s) sur au moins un support de stockage lisible par ordinateur du système (110), dans lequel lesdites instructions exécutables par un processeur comprennent des instructions qui, lorsqu'elles sont exécutées par ledit processeur :

      - fournissent (230) ledit courant, ladite tension et ladite température en fonction du temps et ladite OCV en fonction du SoC à un algorithme d'identification basé sur un modèle thermique de batterie ;
      - exécutent ledit algorithme d'identification, ce dernier étant configuré pour déterminer ledit EHC en fonction du SoC, dans lequel, pour ladite détermination, l'EHC est défini en fonction de N+1 paramètres $a_0,...,a_N$ prenant des valeurs réelles, dans lequel l'algorithme d'identification est configuré pour déterminer la valeur de chaque paramètre réel $a_0,...,a_N$, en minimisant une différence entre une température de batterie estimée et ladite température mesurée, dans lequel la température de batterie estimée est obtenue en modélisant, avec ledit modèle thermique de batterie, une chaleur générée par la batterie pendant ledit cycle de recharge et de décharge ;
      - délivrent en sortie (250), via une troisième interface (113), l'EHC en fonction du SoC tel que déterminé par l'algorithme d'identification ;

      - ladite troisième interface (113) étant notamment configurée pour afficher l'EHC déterminé.

10. Système (110) selon la revendication 9, comprenant un dispositif de recharge connecté à la première interface (111), configuré pour mettre en œuvre ledit cycle de recharge et de décharge constant effectué à température ambiante et pour acquérir ledit courant, ladite tension et ladite température de la batterie (120) en fonction du temps.

11. Système (110) selon la revendication 9 ou 10, dans lequel lesdites instructions exécutables par un processeur comprennent d'autres instructions qui, lorsqu'elles sont exécutées par ledit processeur :

- ajoutent (240) une courbe sinusoïdale (802) de l'EHC en fonction du SoC à l'EHC déterminé précédemment (801) en fonction du SoC afin de créer un nouvel EHC (803) en fonction du SoC, dans lequel ladite courbe sinusoïdale (802) est définie par un ensemble de paramètres réels d'adaptation ;
- fournissent ledit nouvel EHC (803) à l'algorithme d'identification, dans lequel ledit algorithme d'identification est en outre configuré pour optimiser les valeurs des paramètres réels d'adaptation dudit ensemble en minimisant ladite différence entre la température de batterie estimée et ladite température mesurée ;
- lancent ou exécutent ledit algorithme d'identification qui, lors de l'exécution, est configuré pour délivrer en sortie ledit nouvel EHC (803) tel qu'obtenu avec les valeurs optimisées des paramètres réels d'adaptation ;

dans lequel l'EHC délivré en sortie par ladite troisième interface est ledit nouvel EHC obtenu avec les valeurs optimisées des paramètres réels d'adaptation.

12. Système (110) selon l'une des revendications 9 à 11, comprenant un système de gestion thermique de la batterie (120), connecté à ladite troisième interface (113) pour acquérir ledit EHC en fonction du SoC, et configuré pour commander, en fonction dudit EHC, une recharge ou une décharge de la batterie (120) en fonction de sa température.

13. Support non-transitoire lisible par machine stockant des instructions exécutables par une unité de traitement (117) pour amener un système informatique à :

a) recevoir ou acquérir (210) un courant, une tension et une température d'une batterie (120) en fonction du temps, dans lequel ledit courant, ladite tension et ladite température ont été mesurés simultanément pendant un cycle de recharge et de décharge constant ;
b) recevoir ou acquérir (220) une tension en circuit ouvert, ci-après « OCV », de la batterie en fonction de son état de charge, ci-après « SoC » ;
c) fournir (230) ledit courant, ladite tension et ladite température en fonction du temps et ladite OCV en fonction du SoC à un algorithme d'identification basé sur un modèle thermique de batterie ;
d) exécuter ledit algorithme d'identification, ce dernier étant configuré pour déterminer ledit EHC en fonction du SoC, dans lequel, pour ladite détermination, l'EHC est défini en fonction de N+1 paramètres réels $a_0,...,a_N$, dans lequel l'algorithme d'identification est configuré pour déterminer la valeur de chaque paramètre réel $a_0,...,a_N$, en minimisant une différence entre une température de batterie estimée et ladite température mesurée, dans lequel la température de batterie estimée est obtenue en modélisant, avec ledit modèle thermique de batterie, une chaleur générée par la batterie (120) pendant ledit cycle de recharge et de décharge ;
e) délivrer en sortie (240) l'EHC en fonction du SoC tel que déterminé par l'algorithme d'identification.

14. Support non-transitoire lisible par machine selon la revendication 13, stockant en outre des instructions exécutables par ladite unité de traitement (117) pour amener le système informatique à :

- ajouter (240) une courbe sinusoïdale de l'EHC en fonction du SoC à l'EHC déterminé précédemment en fonction du SoC afin de créer un nouvel EHC en fonction du SoC, dans lequel ladite courbe sinusoïdale est définie par un ensemble de paramètres réels d'adaptation,
- fournir ledit nouvel EHC à l'algorithme d'identification, dans lequel ledit algorithme d'identification est en outre configuré pour optimiser les valeurs des paramètres réels d'adaptation dudit ensemble en minimisant ladite différence entre la température de batterie estimée et ladite température mesurée ;
- lancer ou exécuter ledit algorithme d'identification qui, lors de l'exécution, est configuré pour délivrer en sortie ledit nouvel EHC avec les valeurs optimisées des paramètres réels d'adaptation ;

dans lequel l'EHC délivré en sortie en fonction du SoC est ledit nouvel EHC tel qu'obtenu avec les valeurs optimisées des paramètres réels d'adaptation.

15. Support non-transitoire lisible par machine selon la revendication 13 ou 14, stockant en outre des instructions exécutables par ladite unité de traitement (117) pour amener le système informatique à :

- mettre en œuvre une gestion thermique de la batterie en fonction de l'EHC déterminé en fonction du SoC, dans lequel ladite gestion thermique de la batterie est configurée pour commander, en fonction dudit EHC, une recharge ou une décharge de la batterie en fonction de sa température.

100

FIG 1

200

FIG 2

300

A

[A]

2

-1

-4

current [A] x10³

0  2  4  6  8  10  12  14  16  18

X: Time [s]

B

[V]

4.2

3.4

2.6

voltage [V] x10³

0  2  4  6  8  10  12  14  16  18

X: Time [s]

C

[degC]

31

26

temperature [degC]

x10³

0  2  4  6  8  10  12  14  16  18

X: Time [s]

FIG 3

400

FIG 4

FIG 5

FIG 6

$$m \cdot C_p \cdot \frac{dT_{cell}}{dt} + S_{conv} \cdot h_{conv} \cdot (T_{cell} - T_{amb})$$
$$= I \cdot (OCV - U_{batt}) + I \cdot T_{cell} \cdot \frac{dU_{OC}}{dT_{cell}}$$

FIG 7

FIG 8

# FIG 9

**Step 230**

Optimization algorithm

Parameters adjusting $C_p$, $h_{conv}$, $a_0$, $a_1$, ..., $a_N$

Expression to calculate $T_{cell}$

$$m \cdot C_p \cdot \frac{dT_{cell}}{dt} + S_{conv} \cdot h_{conv} \cdot (T_{cell} - T_{amb}) = I \cdot (U_{OC} - U_{batt}) + I \cdot T_{cell} \cdot \frac{dU_{OC}}{dT_{cell}}$$

$I$, $U_{batt}$, $U_{OC}$, $T_{amb}$, $m$, $S_{conv}$

$T_{cell\,estimated}$

$T_{cell}$ measured

$+$ $-$ $e$

**Results of step 1**

$\frac{dU_{OC}}{dT_{cell}}$

$C_p$

$h_{conv}$

901

**Step 240**

Optimization algorithm

Parameters adjusting $SoC_0$, $?SoC$, $y_1$, $y_2$, $y_3$

902

New $dU/dT$

SoC

New $dU_{OC}/dT_{cell}$

Expression to calculate $T_{cell}$

$$m \cdot C_p \cdot \frac{dT_{cell}}{dt} + S_{conv} \cdot h_{conv} \cdot (T_{cell} - T_{amb}) = I \cdot (U_{OC} - U_{batt}) + I \cdot T_{cell} \cdot \frac{dU_{OC}}{dT_{cell}}$$

$I$, $U_{batt}$, $U_{OC}$, $T_{amb}$, $m$, $S_{conv}$

$T_{cell\,estimated}$

$T_{cell}$ measured

$+$ $-$ $e$

110

111

112

116

117

113

114

115  120

FIG 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022116037 A

**Non-patent literature cited in the description**

- **X.-F. ZHANG et al.** Potentiometric measurement of entropy change for lithium batteries. *Phys. Chem. Chem. Phys.*, April 2017, vol. 19 (15), 9833-9842
- **N. DAMAY** ; **C. FORGEZ** ; **M.-P. BICHAT** ; **G. FRIEDRICH**. Thermal modeling of large prismatic LiFePO4/graphite battery. Coupled thermal and heat generation models for characterization and simulation. *Journal of Power Sources*, June 2015, vol. 283, 37-45

- **Z. GENG** ; **J. GROOT** ; **T. THIRINGER**. A Time- and Cost-Effective Method for Entropic Coefficient Determination of a Large Commercial Battery Cell. *IEEE Transactions on Transportation Electrification*, March 2020, vol. 6 (1), 257-266
- Applying a numerical optimization to determine the entropic heat coefficient of a battery. **LENZ MARTIN et al.** APPLIED THERMAL ENGINEERING. PERGAMON, 12 April 2022, vol. 211